# EUROPEAN PATENT SPECIFICATION

(11) **EP 1 296 345 B1**
(45) Date of publication and mention of the grant of the patent: **01.06.2011**
(21) Application number: 02354127.9
(22) Date of filing: 02.09.2002
(51) Int. Cl.: H01H 71/12, H05K 5/02, H01H 9/02, H05K 1/18

(54) **Flexible printed circuit adhered to metal frame**
Ein auf einen Metalramen aufgeklebter flexible Leiterplatte
Plaquette de circuit imprimé souple collée sur un châssis en métal

(30) Priority: 19.09.2001 US 955660
(43) Date of publication of application: 26.03.2003
(73) Proprietor: Schneider Electric Japan Ltd., Taito-ku Tokyo (JP)
(72) Inventor: Meehleder, Steven, 38050 Grenoble Cedex 09 (FR); Grattan, Brian, 38050 Grenoble Cedex 09 (FR)
(74) Representative: Picard, Laurent

(56) References cited:
- DE-A- 4 310 705
- DE-U- 29 617 603
- GB-A- 1 363 805
- US-A- 4 506 198
- US-A- 4 858 073
- US-A- 5 103 375
- US-A- 6 059 382

## Description

### FIELD OF THE INVENTION

The present invention relates generally to electrical circuit breakers, and, more specifically, to the assembly of electrical devices used in a circuit breaker by using flexible circuit boards.

### BACKGROUND OF THE INVENTION

Electrical circuit breakers typically include devices such as actuators or a solenoids for effecting the movement of certain components in response to signals from one or more control circuits. These control circuits are typically mounted on rigid circuit boards that are mounted directly beside the devices being controlled, and are connected to those devices by wires. This arrangement can create problems when space becomes critical because space must be provided not only for the mounting of the circuit board but also to allow for the installation of the board and the wires that connect it to the device it is controlling. Accordingly, from this perspective the design of circuit breakers has met a design barrier when the object is to make a circuit breaker that is both small and economical.

### SUMMARY OF THE INVENTION

A principal object of the present invention to allow the placement of electronic components that are used to control a particular electrical device in an electrical circuit breaker, such as an actuator or a solenoid, directly onto the housing of that device without requiring a significant amount of additional space.

Another object of the invention is to provide a more efficient dissipation of heat generated by the control circuitry, without having to add extra components such as, for example, a cooling fan. A related object is to reduce the dielectric separation between the electronic components and a heat sink.

In accordance with the present invention, the foregoing objectives are realized by a circuit breaker that comprises a controllable electrical device according to claim 1.

The electrical apparatus is an electro-mechanical device. Furthermore, the combination of the flexible circuit board and at least one electrical component can comprise a control system for the electro-mechanical device, or a system that sends a control signal in response to a signal received from the electro-mechanical device, or it can transmit processed signals to a location outside the electrical device.

In other embodiments the electro-mechanical device is a circuit breaker, a motor, a relay, a rheostat, a solenoid, an actuator, or a position sensor. For example, the invention can be applied to control an under voltage release solenoid, to control a motor, to take readings from a position detector, to control any general solenoid, or to take readings from a temperature sensor that is on a pipe.

Document US 6 059 382 discloses a device according to the preamble of claim 1.

### BRIEF DESCRIPTION OF THE DRAWINGS

In the drawings:

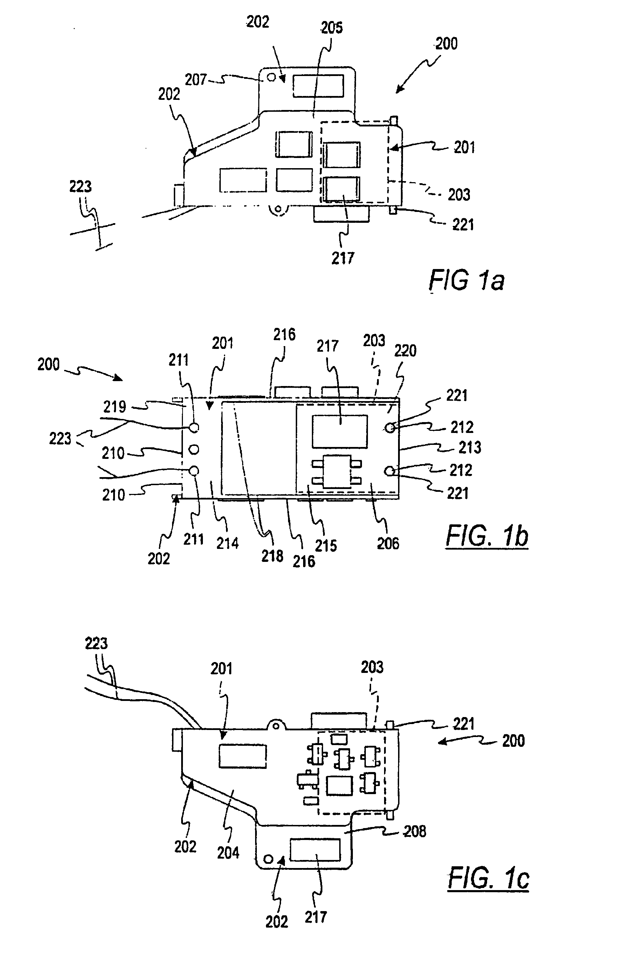

Fig. 1a is a side elevation view of an under voltage release embodying the invention;
Fig. 1b is a top plan view of the under voltage release shown in Fig. 3a;
Fig. 1c is a front elevation view of the under voltage release shown in Fig. 3a;
Fig. 2a is a top plan view showing the exterior surface of the flexible circuit board included in the under voltage release shown in shown in Figs. 1a - 1c;
Fig. 2b is a side elevation view of the flexible circuit board shown in Fig. 2a;
Fig. 2c is a bottom plan view of the flexible circuit board shown in Fig. 2a;
Fig. 3a is a rear elevation view of the metal C-frame included in the under voltage release shown in Figs. 1a - 1c;
Fig. 3b is a top plan view of the metal C-frame shown in Fig. 3a; and
Fig. 3c is a front elevation view of the metal C-frame shown in Fig. 3a.

### DETAILED DESCRIPTION OF THE ILLUSTRATED EMBODIMENTS

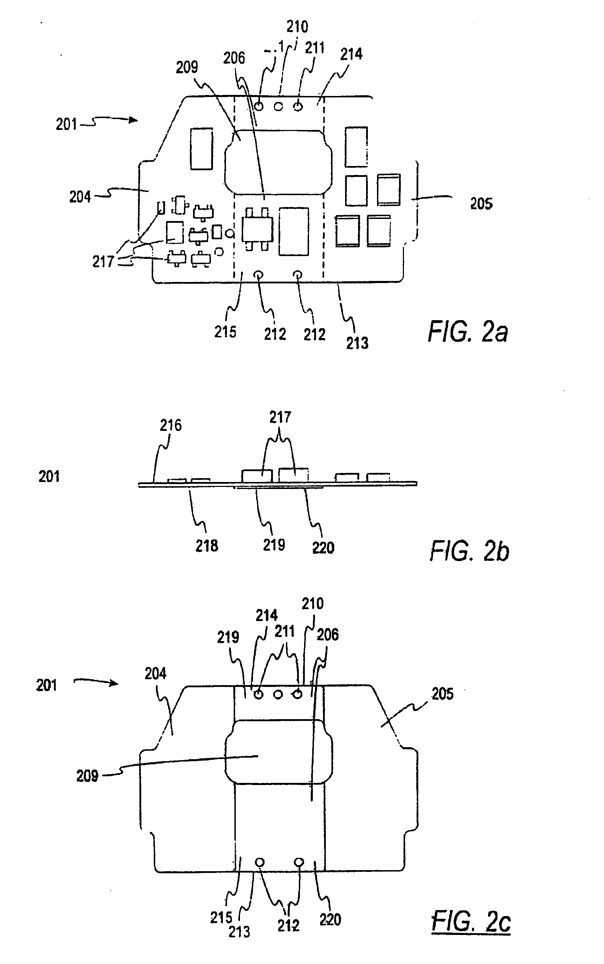

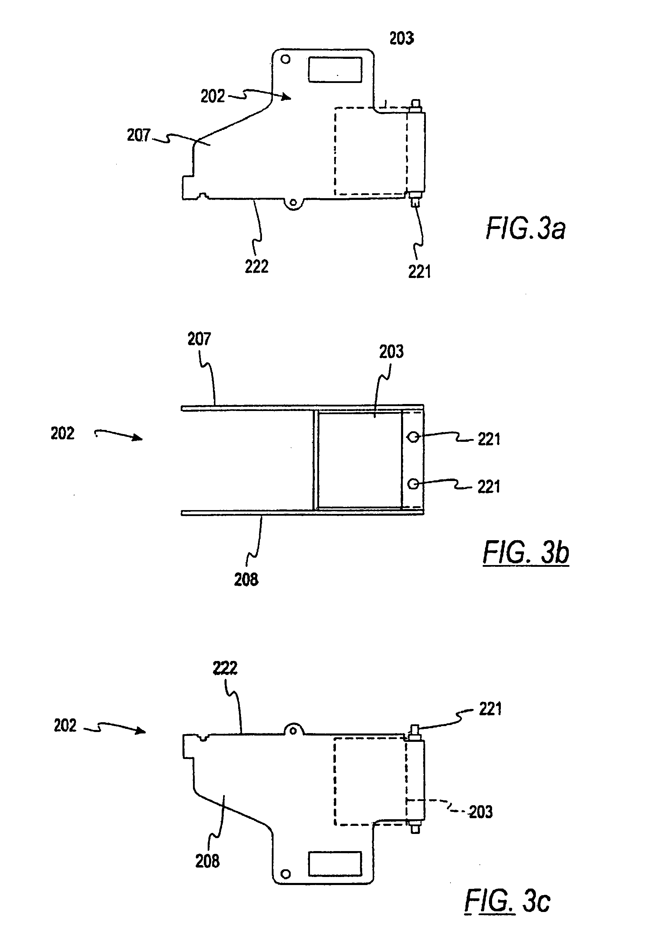

Referring now to the drawings, an under voltage release 200 for use in an electrical circuit breaker comprises a flexible circuit board 201 attached to the outer surface of a metal C-shaped housing 202 containing a solenoid 203. The flexible circuit board 201 has a pair of end sections 204 and 205 that are mirror images of each other, and are connected to each other by a joining section 206 (see Figs. 2a-2c). The two end sections 204 and 205 have generally rectangular shapes that approximately resemble the shapes of a pair of side surfaces 207 and 208 of a metal housing (see Figs. 3a-3c).

The joining section 206 is rectangularly shaped and extends across the bottom of the housing 202. A rectangular aperture 209 in the joining section 206 is offset toward a lead wire edge 210 where two lead wires 223 pass through a pair of holes 211 in the joining section 206. A second pair of holes for the solenoid wires are located near the opposite edge 213 of the joining section 206.

The flexible circuit board 201 has an exterior surface 216 on which a plurality of electronic components 217 are mounted. On the interior surface 218, an adhesive coating is provided on the two end sections 204 and 205 to bond the flexible circuit board to the side walls of the housing 202. The interior surface 218 of the joining section 206 includes reinforcing stiffener materials 219 and 220 on opposite sides of the aperture 217 because this intermediate portion of the flexible circuit board is not supported by a corresponding surface on the C-shaped housing 202. The flexible circuit board 201 is generally made of several layers of polyimide, adhesive, and RA copper sandwiched together, with the adhesive coating on the interior surfaces of the two sections 204 and 205 as the last layer.

During mounting of the flexible circuit board 201 on the housing 202, the two holes 212 are fitted over a pair of solenoid pins 221 extending downwardly from the housing adjacent to the solenoid 203. The flexible circuit board 201 is then secured to the housing 202 by soldering the solenoid pins 221 to conductors formed in the flexible circuit board 201 adjacent the holes 212. This provides a direct connection between the flexible circuit board 201 and the solenoid 203. The lead wires 223 are similarly secured to the flexible circuit board 201 by soldering the lead wires 223 to conductors formed in the flexible circuit board 201 adjacent the holes 211. Thus, the requisite connections between the solenoid and the control circuitry on the flexible circuit board can be effected by a few simple solder connections, and the mounting of the flexible circuit board 201 directly on the outside surface of the housing 202 provides an extremely compact assembly that reduces the overall size of the circuit breaker in which the solenoid is utilized.

The two end sections 204 and 205 of the flexible circuit board are wrapped around the two elongated edges on the bottom of the housing 202 and pressed against the respective side walls 208 and 207 so that the adhesive coating on the interior surfaces of the end sections 204, 205 bonds the flexible circuit board to the housing 202. Adhering the flexible circuit board 201 directly onto the housing 202 minimizes the thickness of dielectric material separating the electronic components 217 and the housing 202, thereby permitting efficient transfer of heat from the electronic components 217 on the flexible circuit board 201 to the conductive housing 202 for dissipation to the surroundings. The principal heat-generating components on the flexible circuit board 201 are preferably located on the two end sections 204, 205 which are bonded to the two metal walls 208, 207 which provide a large surface area for efficient heat transfer.

While the invention has described with specific reference to a solenoid for use in electrical circuit breakers, it will be appreciated that this invention can be utilized in other applications. For example, the electro-mechanical device may be a circuit breaker, a motor, a relay, a rheostat, an actuator or a position sensor. Similarly, the control circuit can be used to control a motor, to take readings from a position detector, to control any general solenoid, to take readings from a temperature sensor that is on a pipe, to send a control signal in response to a signal received from the electro-mechanical device, or to transmit processed signals to a location outside the electrical device.

## Claims

1. An electrical device comprising:
a housing (202) formed of heat conductive material and having a plurality of exterior surfaces (216);
an electrical apparatus positioned within said housing; and
a flexible printed circuit board (201) attached to at least a portion of the exterior surfaces (216) of said housing, said board having a circuit printed thereon, and further having at least one heat-generating electrical component (217) mounted on the outside surface thereof, heat generated upon operation of said electrical component (217) is transferred to said housing and dissipated therefrom into the surroundings; whereby said electrical apparatus is an electro-mechanical device, said printed circuit and said at least one electrical apparatus comprising a control system for said electro-mechanical device.
**characterized in that** said flexible circuit board (201) is adhered to at least some of said plurality of exterior surfaces (216).

2. An electrical device in accordance with claim 1 in which said electro-mechanical device is a circuit breaker.

3. An electrical device in accordance with claim 1 in which said electro-mechanical device is a motor.

4. An electrical device in accordance with claim 1 in which said electro-mechanical device is a relay.

5. An electrical device in accordance with claim 1 in which said electro-mechanical device is a rheostat.

6. An electrical device in accordance with claim 1 in which said electro-mechanical device is a solenoid.

7. An electrical device in accordance with claim 1 in which said electro-mechanical device is an actuator.

8. An electrical device in accordance with claim 1 in which said electro-mechanical device is a position sensor.

9. An electrical device in accordance with claim 1 in which said printed circuit and said at least one electrical component comprises a system for receiving and processing signals from said electro-mechanical device.

10. An electrical device in accordance with claim 9, in which said partial circuit and said at least one electrical component further comprise a system for sending a control signal to said electro-mechanical device in response to a signal received from said electro-mechanical device.

11. An electrical device in accordance with claim 9, in which said printed circuit and said at least one electrical component further comprise means for transmitting processed signals to a location outside said electrical device.

12. A method for constructing an electrical device according to claim 1, comprising:
providing a housing formed of heat conductive material;
providing an electrical apparatus within said housing; and
attaching a flexible printed circuit board to at least a portion of the surface of said housing, said board having a circuit printed thereon, and further having at least one heat-generating electrical component mounted on the outside surface thereof,
whereby heat generated upon operation of said electrical component is transferred to said housing and dissipated therefrom into the surroundings.

13. A method in accordance with claim 12 in which said housing has a plurality of exterior surfaces and further comprising adhering said flexible circuit board to at least some of said plurality of exterior surfaces.

## Patentansprüche

1. Elektrische Einrichtung mit einem Gehäuse (202) aus einem wärmeleitenden Material mit mehreren Außenflächen (216), einem in dem genannten Gehäuse angeordneten elektrischen Gerät sowie einer an mindestens einem Teil der Außenflächen (216) des genannten Gehäuses befestigten flexiblen Leiterplatte (201), wobei die Leiterplatte eine gedruckte Schaltung trägt und mindestens ein an ihrer Außenseite montiertes, wärmeerzeugendes elektrisches Bauteil umfasst (217), die im Betrieb des genannten elektrischen Bauteils (217) erzeugte Wärme auf das genannte Gehäuse übertragen und von dort an die Umgebung abgegeben wird, das genannte elektrische Gerät als elektromechanische Einrichtung ausgebildet ist und die genannte flexible Leiterplatte sowie das genannte mindestens einfach vorhandene elektrische Gerät ein Steuersystem zur Ansteuerung der genannte elektromechanischen Einrichtung umfassen, **dadurch gekennzeichnet, dass** die genannte flexible Leiterplatte (201) auf mindestens einen Teil der Außenflächen (216) aufgeklebt wird.

2. Elektrische Einrichtung nach Anspruch 1, bei der die genannte elektromechanische Einrichtung als Leistungsschalter ausgebildet ist.

3. Elektrische Einrichtung nach Anspruch 1, bei der die genannte elektromechanische Einrichtung als Motor ausgebildet ist.

4. Elektrische Einrichtung nach Anspruch 1, bei der die genannte elektromechanische Einrichtung als Relais ausgebildet ist.

5. Elektrische Einrichtung nach Anspruch 1, bei der die genannte elektromechanische Einrichtung als regelbarer Widerstand ausgebildet ist.

6. Elektrische Einrichtung nach Anspruch 1, bei der die genannte elektromechanische Einrichtung als Spule ausgebildet ist.

7. Elektrische Einrichtung nach Anspruch 1, bei der die genannte elektromechanische Einrichtung als Stellglied ausgebildet ist.

8. Elektrische Einrichtung nach Anspruch 1, bei der die genannte elektromechanische Einrichtung als Positionssensor ausgebildet ist.

9. Elektrische Einrichtung nach Anspruch 1, bei der die genannte gedruckte Schaltung und das genannte mindestens einfach vorhandene elektrische Bauteil ein System umfassen, um Signale von der genannten elektromechanischen Einrichtung zu empfangen und zu verarbeiten.

10. Elektrische Einrichtung nach Anspruch 9, bei der die genannte gedruckte Schaltung und das genannte mindestens einfach vorhandene elektrische Bauteil darüber hinaus ein System umfassen, um nach dem Empfang eines Signals von der genannten elektromechanischen Einrichtung die genannte elektromechanische Einrichtung mit einem Steuersignal zu beaufschlagen.

11. Elektrische Einrichtung nach Anspruch 9, bei der die genannte gedruckte Schaltung und das genannte mindestens einfach vorhandene elektrische Bauteil Mittel umfassen, um verarbeitete Signale an einen Ort außerhalb der genannten elektrischen Einrichtung zu übertragen.

12. Verfahren zur Herstellung einer elektrischen Einrichtung nach Anspruch 1, das die Bereitstellung eines Gehäuses aus einem wärmeleitenden Material, die Bereitstellung eines in dem genannten Gehäuse angeordneten elektrischen Gerätes sowie der Befestigung einer flexiblen Leiterplatte an mindestens einem Teil der Oberfläche des genannten Gehäuses umfasst, wobei die genannte Leiterplatte eine gedruckte Schaltung trägt und mindestens ein an ihrer Außenseite montiertes, wärmeerzeugendes elektrisches Bauteil umfasst und die im Betrieb des genannten elektrischen Bauteils erzeugte Wärme auf das genannte Gehäuse übertragen und von dort an die Umgebung abgegeben wird.

13. Verfahren nach Anspruch 12, bei dem das genannte Gehäuse mehrere Außenflächen aufweist, und das darüber hinaus das Aufkleben der genannten flexiblen Leiterplatte auf mindestens einen Teil der Außenflächen umfasst.

## Revendications

1. Dispositif électrique comprenant :
un logement (202) constitué d'un matériau conducteur de chaleur et pourvu d'une pluralité de surfaces externes (216);
un appareil électrique positionné à l'intérieur dudit logement; et
une carte de circuit imprimé souple (201) attachée à au moins une portion des surfaces externes (216) dudit logement, ladite carte portant un circuit imprimé, et
étant en outre pourvue d'au moins un composant électrique générateur de chaleur (217) monté sur sa surface externe, la chaleur générée lors du fonctionnement dudit composant électrique (217) étant transférée audit logement et dissipée vers l'extérieur de celui-ci, où ledit appareil électrique est un dispositif électromécanique, ledit circuit imprimé et ledit au moins un appareil électrique comprenant un système de commande dudit dispositif électromécanique **caractérise en ce que** ladite carte de circuit souple (201) est solidarisée à au moins certaines de ladite pluralité de surfaces externes (216).

2. Dispositif électrique selon la revendication 1 dans lequel ledit dispositif électromécanique est un disjoncteur.

3. Dispositif électrique selon la revendication 1 dans lequel ledit dispositif électromécanique est un moteur.

4. Dispositif électrique selon la revendication 1 dans lequel ledit dispositif électromécanique est un relai.

5. Dispositif électrique selon la revendication 1 dans lequel ledit dispositif électromécanique est un rhéostat.

6. Dispositif électrique selon la revendication 1 dans lequel ledit dispositif électromécanique est un solénoïde.

7. Dispositif électrique selon la revendication 1 dans lequel ledit dispositif électromécanique est un actionneur.

8. Dispositif électrique selon la revendication 1 dans lequel ledit dispositif électromécanique est un capteur de position.

9. Dispositif électrique selon la revendication 1 dans lequel ledit circuit imprimé et ledit au moins un composant électrique comprennent un système de réception et de traitement de signaux en provenance dudit dispositif électromécanique.

10. Dispositif électrique selon la revendication 9 dans lequel ledit circuit imprimé et ledit au moins un composant électrique comprennent en outre un système d'émission d'un signal de commande vers ledit dispositif électromécanique en réponse à un signal reçu depuis ledit dispositif électromécanique.

11. Dispositif électrique selon la revendication 9 dans lequel ledit circuit imprimé et ledit au moins un composant électrique comprennent en outre des moyens de transmission de signaux traités vers un emplacement situé en dehors dudit dispositif électrique.

12. Procédé de fabrication d'un dispositif électrique selon la revendication 1 comprenant les étapes suivantes :
prévoir un logement constitué d'un matériau conducteur de chaleur;
prévoir un appareil électrique à l'intérieur dudit logement; et
solidariser une carte de circuit imprimé souple à au moins une portion de la surface dudit logement, ladite carte portant un circuit imprimé, et étant en outre pourvue d'au moins un composant électrique générateur de chaleur monté sur sa surface externe,
dans lequel la chaleur générée lors du fonctionnement dudit composant électrique est transférée audit logement et dissipée vers l'extérieur de celui-ci.

13. Procédé selon la revendication 12 dans lequel ledit logement est pourvu d'une pluralité de surfaces externes, et comprend en outre la solidarisation de ladite carte de circuit souple à au moins certaines de ladite pluralité de surfaces externes.
